Europäisches Patentamt

European Patent Office

Office européen des brevets

(11) Veröffentlichungsnummer: **0 403 788**
**A2**

(12) **EUROPÄISCHE PATENTANMELDUNG**

(21) Anmeldenummer: **90109104.1**

(22) Anmeldetag: **15.05.90**

(51) Int. Cl.⁵: **G01V 3/10**

(30) Priorität: **20.06.89 DE 3920081**

(43) Veröffentlichungstag der Anmeldung:
**27.12.90 Patentblatt 90/52**

(84) Benannte Vertragsstaaten:
**DE FR GB SE**

(71) Anmelder: **INSTITUT DR. FRIEDRICH FÖRSTER PRÜFGERÄTEBAU GMBH & CO. KG**
**In Laisen 70, Postfach 15 84**
**D-7410 Reutlingen(DE)**

(72) Erfinder: **Seichter, Helmut, Dr. Dipl.-Phys.**
**Elsterweg 112**
**D-7417 Pfullingen(DE)**
Erfinder: **Ausländer, Klaus, Dipl.-Ing.**
**Peter-Cornelius-Strasse 19**
**D-7410 Reutlingen(DE)**
Erfinder: **Fabris, Hans-Jürgen, Dipl.-Ing. (FH)**
**Scheffelweg 29**
**D-7417 Pfullingen(DE)**
Erfinder: **Möck, Karl-Heinz**
**Sudetendeutsche Strasse 25**
**D-7410 Reutlingen(DE)**
Erfinder: **Patzwald, Wolfgang, Dipl.-Phys.**
**Gumpperweg 36**
**D-7410 Reutlingen(DE)**

(54) **Suchspulenanordnung.**

(57) Es wird eine Suchspulenanordnung für ein induktives Suchgerät beschrieben, bei der ein in Leiterplattentechnik aufgebauter Schirm (32) zum Einsatz kommt. Dieser besitzt eine Trägerschicht (8) und einen auf der letzteren aufgebrachten dünnen metallischen Belag (6), der in eine Vielzahl von parallelen Leiterbahnen (36, 38) aufgelöst ist. Durch Verbindungsbahnen (40, 42, 46, 48) sind die Leiterbahnen (30,38) untereinander und mit einem Bezugspotential elektrisch verbunden. Die Erfindung kann mit großem Vorteil bei Suchspulen angewendet werden, die in Multilayertechnik aufgebaut sind. Jedoch ist ihr Einsatz auch bei in beliebiger Leiterplattentechnik beigestellten Suchspulen und bei herkömmlich gewickelten Suchspulen sinnvoll und nützlich.

Fig 4

## Suchspulenanordnung

Die Erfindung betrifft eine Suchspulenanordnung für ein induktives Suchgerät gemäß dem Oberbegriff von Patentanspruch 1. Induktive Suchgeräte benutzt man zum Auffinden von Gegenständen aus elektrisch leitenden Werkstoffen, die der unmittelbaren Wahrnehmung durch den Menschen entzogen sind, weil sie sich z.B. unter dem Erdboden befinden oder von anderen Stoffen geringer elektrischer Leitfähigkeit umgeben sind. Dabei ist es sowohl möglich, das Suchgerät über eine zu durchsuchende Fläche hinwegzuführen, als auch zu überprüfende Güter an einem ortsfesten Suchgerät vorbeizuführen. In beiden Fällen ergibt sich bei einer Annäherung zwischen Suchobjekten und Suchgerät eine elektrische Signalspannung, die in geeigneter Weise in ein vom Menschen wahrnehmbares Signal, etwa ein akustisches oder optisches, umgewandelt wird.

Induktive Suchgeräte , seien sie als Minensuchgerät, als sogenanntes "Schatzsuchgerät" oder als ortsfester Metalldetektor aufgebaut, besitzen im allgemeinen eine hohe Empfindlichkeit. Dies hat zu Folge, sind nicht besondere Gegenmaßnahmen getroffen, daß schon die Annäherung elektrisch nicht leitender oder schwach leitender Gegenstände eine unerwünschte und störende Signalspannung entstehen läßt. Ursache dieser Erscheinung sind das im Bereich der Suchspulenanordnung sich ausbreitende elektrische Feld und die durch die Annäherung der genannten Gegenstände veränderte Dielektrizitätskonstante im Feldbereich. Die dadurch bewirkten kapazitiven Ströme verursachen eine Störung des Abgleichs und rufen so Signalspannungen hervor. Die bekannteste Gegenmaßnahme besteht darin, daß man die Ausbreitung der elektrischen Felder außerhalb der Suchspulenanordnung soweit wie möglich verhindert, indem man die Suchspule mit einem elektrischen Schirm umgibt, der auf ein Bezugspotential, im allgemeinen Massepotential, gelegt ist.

Bei konventionellen Suchspulenanordnungen geschieht dies, wie beispielsweise in DE-GM 83 36 122 beschrieben, indem man die Suchspule mit dem Schirm umwickelt, so daß die letztere schließlich ganz vom Schirm umhüllt ist. Bei einem derartigen Schirm kann es sich um eine metallische Folie, ein netzartiges Geflecht aus dünnen Drähten oder um einen einfachen Draht handeln, von dem eine dichte Lage auf der Suchspule angebracht worden ist. Man muß dabei immer darauf achten, daß der Schirm keine geschlossene Schleife bildet. In die Schleife induzierte Ströme würden auf die Suchspule zurückwirken und in ihr Störsignale entstehen lassen. Aber auch bereits die im Schirm hervorgerufenen Wirbelströme verursachen in der Suchspule Störsignale, die insbesondere deshalb sehr unerwünscht sind, weil sie sich unter Temperatureinfluß ständig langsam verändern. Metallfolien können daher nur bei niedriger Frequenz oder bei entsprechend großem Abstand zwischen Schirm und Suchspule Verwendung finden. Das gleiche gilt auch für netzartige Geflechte, wenn diese nicht aus gegeneinander isolierten Drähten angefertigt sind.

Aus GB-A1 22 05 408 ist eine Suchspulenanordnung bekannt, bei der die Suchspule in einen Block aus Kunststoff eingegossen ist. Der letztere ist mit einem geschlossenen metallischen Schirm ummantelt, der jedoch von der Suchspule einen gebührenden Abstand einhalten muß, um das Wirksamwerden von Wirbelströmen im Schirm zu vermeiden. In der gleichen Druckschrift ist ein anderer Schirm beschrieben, der wegen der geringeren elektrischen Leitfähigkeit seines Werkstoffes enger an die Suchspule angenähert werden kann. Es handelt sich dabei um einen kohlenstoffhaltigen Werkstoff wie etwa Graphit, der in flüssiger Form auf die Innenfläche des Suchspulenrahmens aufgebracht wird, um dort auszuhärten. Der zuletzt beschriebene Schirm dient im vorliegenden Fall zur Ableitung elektrostatischer Aufladungen und ist für die Unterdrückung kapazitiver Störeffekte nur bedingt geeignet. Insbesondere ist die Herstellung eines einwandfreien Kontaktes mit dem kohlenstoffhaltigen Werkstoff problematisch.

Der Erfindung liegt demgegenüber die Aufgabe zugrunde, eine Suchspulenanordnung gemäß dem Oberbegriff von Anspruch 1 in einfacher Weise mit einem wirksamen Schirm zu versehen.

Diese Aufgabe wird gelöst durch eine Suchspulenanordnung, die entsprechend Anspruch 1 gekennzeichnet ist.

Die erfindungsgemäße Aufgabenlösung führt zu einer Suchspule, deren Schirm einfach herstellbar ist und eine gute Abschirmwirkung aufweist. Durch die Auflösung des metallischen Belages in eine Vielzahl von parallelen Leiterbahnen wird die Entstehung von Wirbelströmen bis zu relativ hohen Frequenzen auf ein praktisch unwirksames Maß herabgesetzt, so daß eine enge Nachbarschaft von Suchspule und Schirm problemlos möglich ist. Auf diese Weise kann man zu Suchspulenanordnungen gelangen, die gegen kapazitive Störeffekte voll abgeschirmt sind, ohne daß sich die Abmessungen der Suchspule durch den Schirm merklich vergrößern. Vorteilhafte Ausgestaltungen der Erfindung sind in den Unteransprüchen angegeben. Als besonders vorteilhaft erweist es sich, wenn man die Suchspule ebenfalls als Leiterplatte ausführt, wie dies in der parallellaufenden Patentanmeldung P39 12 840 beschrieben ist und wenn man den Schirm auf die Ober- und / oder Unterseite dieser Leiterplatte aufklebt. Man gelangt auf diese Weise zu einer sehr kompakten Spulenanordnung. Noch bessere Ergebnisse erzielt man, wenn man die Suchspule als mehrlagige Leiterplatte ausführt und wenn der Schirm die oberste und / oder unterste Lage der mehrlagigen Leiterplatte einnimmt. Suchspule und Schirm bilden dann eine organische Einheit und können in einem einzigen Produktionsvorgang in einheitlicher Technik hergestellt werden. Eine alternative Möglichkeit besteht darin, den Schirm aus einer Anzahl von Leiterplatten aufzubauen, die zu einem körperlichen Gebilde zusammengesetzt sind. Dabei können dann mit Vorteil auch biegsame Leiterplatten eingesetzt werden, um gekrümmte Flächen zu realisieren.

Im folgenden wird die Erfindung an Hand von Ausführungsbeispielen und mit Hilfe einiger Figuren näher erläutert. Es zeigen im einzelnen:

Figur 1 die Vorderansicht einer Suchspulenanordnung in Multilayerausführung

Figur 2 die Draufsicht auf eine Lage der Suchspulenanordnung mit dem oberen Teil der Suchspule

Figur 3 dito, jedoch mit dem unteren Teil der Suchspule

Figur 4 dito, jedoch mit der Oberseite des Schirmes

Figur 5 dito, jedoch mit der Unterseite des Schirmes

Figur 6 ein Detail eines Schirmes.

Figur 7 die Vorderansicht einer anderen Suchspulenanordnung

Figur 8 und 9 Layouts für Schirme

Figur 10 die perspektivische Ansicht einer weiteren Suchspulenanordnung

Figur 11 den Entwurf für ein anderes Layout zu einem Schirm

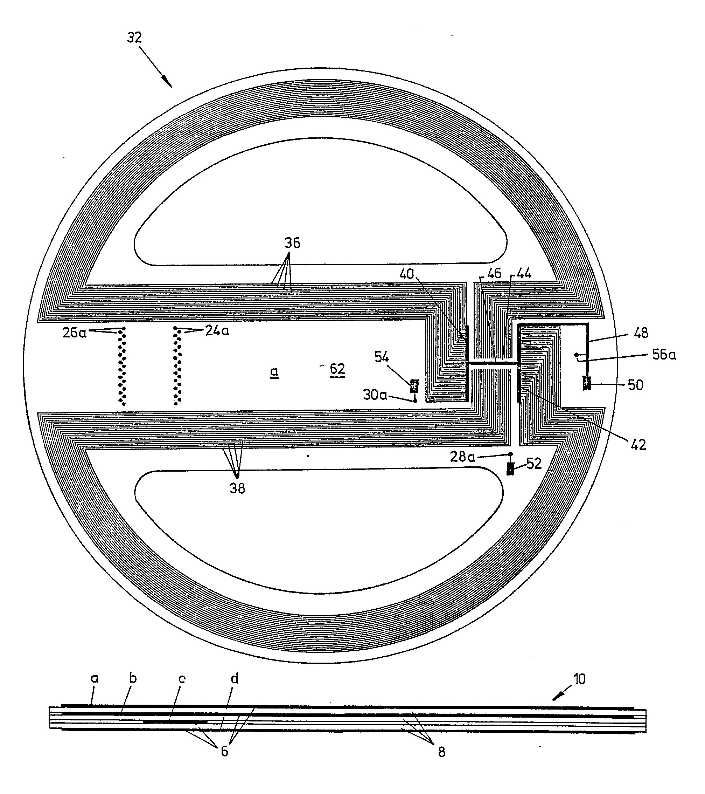

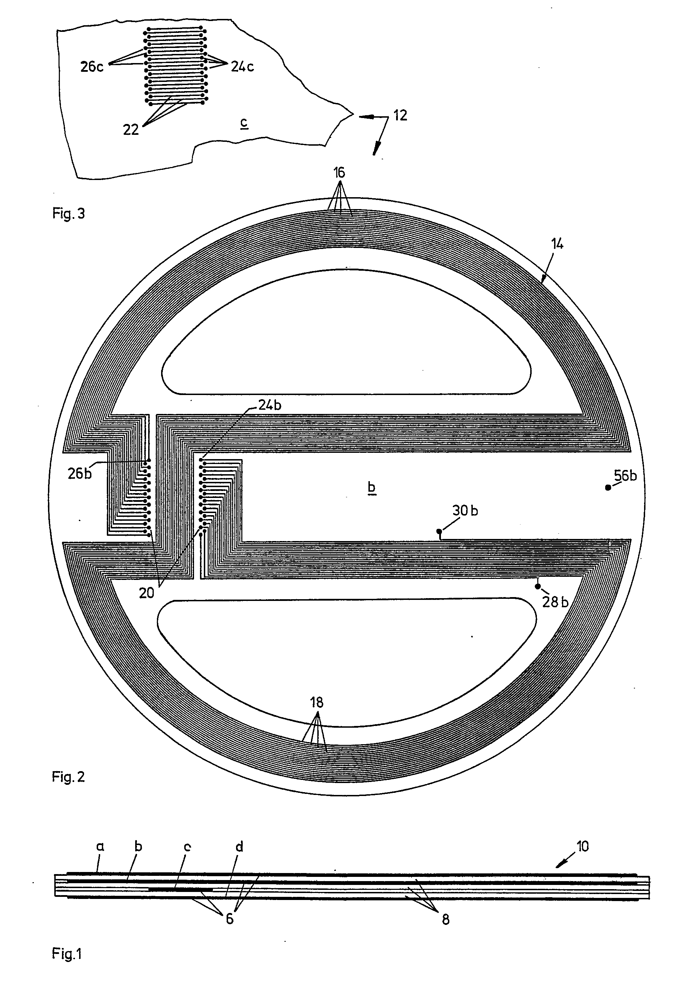

In Figur 1 ist in Vorderansicht eine Suchspulenanordung dargestellt, die als mehrlagige Leiterplatte 10, also in der sogenannten Multilayertechnik aufgebaut ist. Die einzelnen Lagen (a - d) der Leiterplatte 10 sind in den Figuren 2 bis 5, jeweils in Draufsicht, abgebildet. Jede Lage (a - d) besitzt einen metallischen Belag 6, der auf einer isolierenden Trägerschicht 8 ruht. Die Multilayertechnik als solche ist dem einschlägigen Fachmann bekannt und braucht daher hier nicht erörtert zu werden. In den Figuren 2 und 3 findet man die eigentliche Suchspule 12, die die beiden mittleren Lagen c, d umfaßt und deren Aufbau in der älteren Patentanmeldung P 39 12 840 eingehend beschrieben ist. Auf eine Wiederholung der Beschreibung an dieser Stelle kann daher verzichtet werden. Die Suchspule 12 besteht im wesentlichen aus einem Leiterband 14 in Lage b, das aus einer Vielzahl von gegenläufigen Schleifen 16,18 zusammengesetzt ist. An der Kreuzungsstelle dieser Schleifen 16,18 befinden sich Unterbrechungen 20, die durch Brücken 22 in der Lage c überbrückt werden. Die Brücken 22 sind jeweils durch Durchkontaktierungen 24 und 26 mit den Enden der Schleifen 16,18 am Ort der Unterbrechungen 20 verbunden. In den Figuren sind die Bezugszahlen der Durchkontaktierungen mit einem Index versehen, der die jeweilige Lage angibt. Verfolgt man, ausgehend von Durchkontaktierung 28, den Verlauf der Schleifen, so gelangt man über die unterste der Brücken 20 zur äußersten der Schleifen 16, weiter zur innersten der Schleifen 18 und nach Durchlaufen aller weiteren Schleifen zur Durchkontaktierung 30.

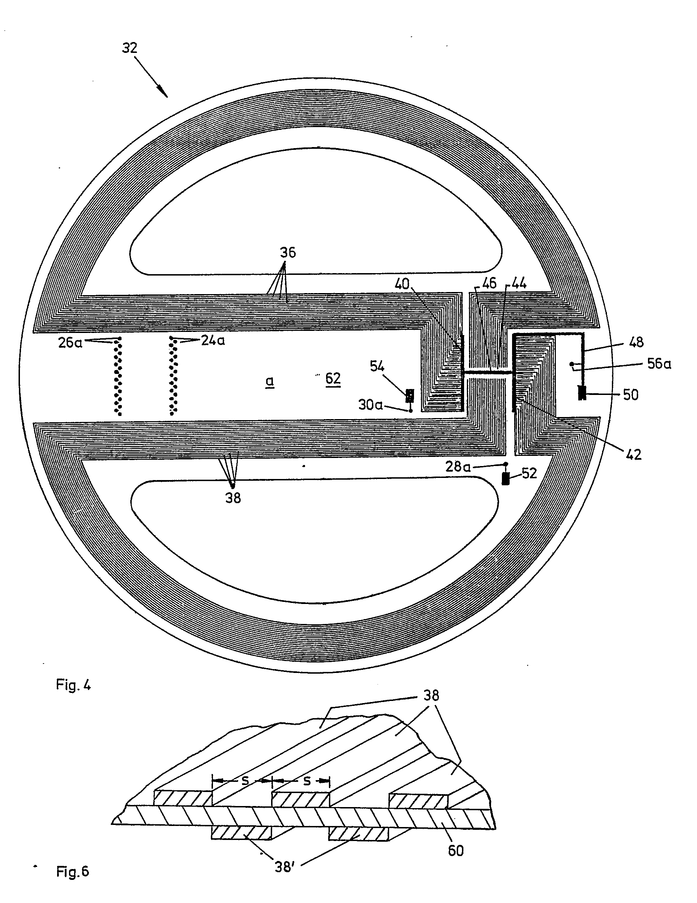

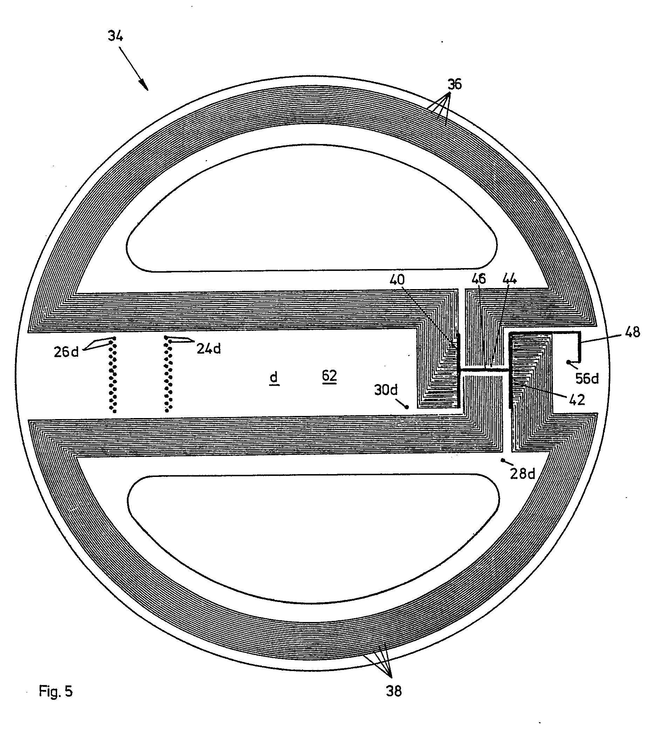

Die beiden Lagen b, c bilden wie gesagt die eigentliche Suchspule 12 und sind in der Mitte der Leiterplatte 10 angeordnet. Demgegenüber konstituieren die Lagen a und d den Schirm 32,34 in den Figuren 4,5 und sind an oberster bzw. unterster Stelle der Leiterplatte 10 angebracht. Sie schließen auf diese Weise die Suchspule 12 vollständig ein. Das hat zur Folge, daß die letztere gegen kapazitive Annäherung von oben und von unten abgesichert ist.

Bei der oberen (32) Hälfte des Schirmes, wie auch bei seiner unteren (34), wurde der Einfachheit halber ein ähnliches Layout verwendet wie bei der Suchspule 12 in Lage b. Eine Vielzahl von parallelen Leiterbahnen 36 und 38 gehen von einer Verbindungsbahn 40 bzw. 42 aus und erstellen so einen dichten Schirm für die darunterliegende Spule 12. Sie enden alle in einem Bereich 44. Eine weitere Verbindungsbahn 46 verbindet die Verbindungsbahnen 40 und 42 untereinander und damit die Leiterbahnen 36 mit den Leiterbahnen 38. Über eine weitere Verbindungsbahn 48 und eine Durchkontaktierung 56 ist die untere (34) Hälfte des Schirmes an dessen obere (32) angeschlossen. Die Leiterbahnen und Verbindungsbahnen der beiden Hälften des Schirmes besitzen im übrigen den gleichen Aufbau. Es wurden daher die gleichen Bezugszahlen verwendet, so daß eine weitere Beschreibung entfallen kann.

Der Anschluß des Schirmes an ein Bezugspotential, normalerweise das Massepotential des Suchgerätes, erfolgt über einen Lötstützpunkt 50. Zwei weitere Lötstützpunkte 52,54 sind einerseits über die Durchkontaktierungen 28,30 mit der Suchspule 12 verbunden und andererseits an den Spuleneingang des Suchgerätes angeschlossen. Die in den Lagen a und d erscheinenden Punkte der Durchkontaktierung 24, 26 dienen lediglich dem Vorgang der Durchkontaktierung und besitzen in den genannten Lagen keine Anschlüsse. Entsprechendes gilt für die Durchkontaktierungen 28,30 in Lage d und 56 in Lage b.

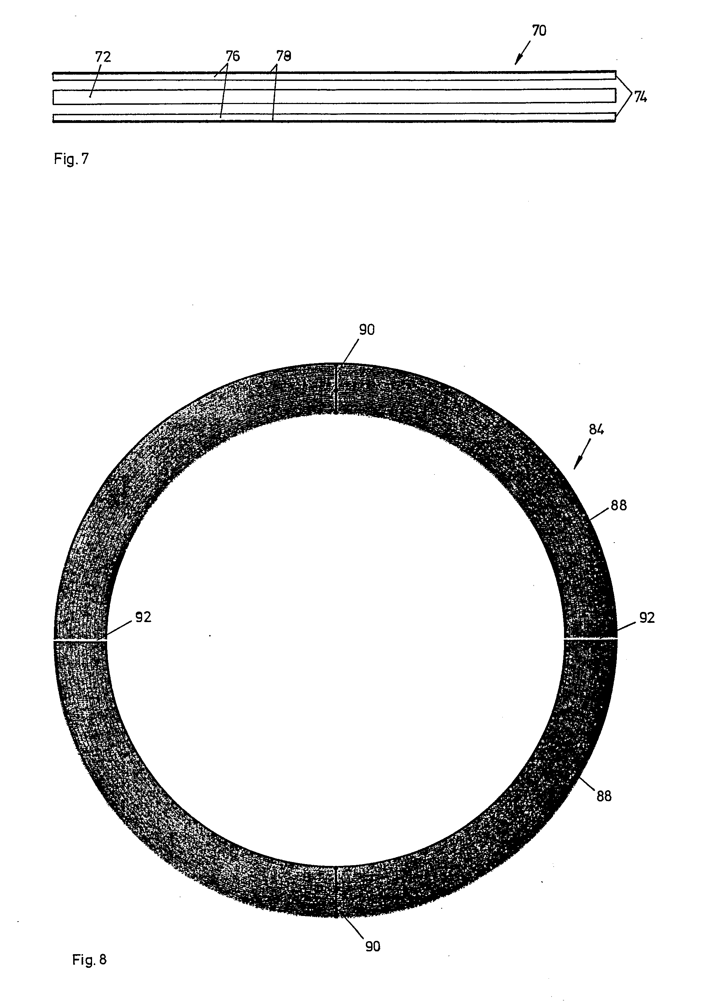

In Figur 6 sind einige Leiterbahnen 38 vergrößert dargestellt. Alle nehmen voneinander den gleichen Abstand s ein. Desgleichen weisen sie auch die gleiche Breite s auf. Soll ein besonders geringer Durchgriff des elektrischen Feldes, also eine besonders gute Abschirmwirkung erzielt werden, so sind, wie im Beispiel vor Figur 6 dargestellt, zwei benachbarte Lagen von parallelen Leiterbahnen 38 und 38' auf den beiden Seiten einer Trägerschicht 60 angebracht. Dabei steht dann, jeweils einer Leiterbahn der einen Lage eine Lücke der anderen Lage gegenüber. Eine wirksamere Abschirmung enthält man auch, wenn man den Schirm so ausführt, daß er die darunter liegende Spule seitlich überragt. Auch kann man die Fläche 62 zwischen den Leiterbahnen 36 und 38 mit parallelen Leiterbahnen ausfüllen, die mit dem restlichen Schirm in Verbindung stehen, muß jedoch darauf achten, daß ein Raum für die Durchführungen und Anschlußlötstützpunkte freibleibt. Man kann grundsätzlich die Leiterbahnen in beliebigen Bahnen ausführen, wird jedoch im Interesse eines leicht zu erstellenden Layouts einfachen geometrischen Bahnen, wie Kreisen und Geraden, den Vorzug geben.

Das zuvor beschriebene Ausführungsbeispiel betrifft den besonders günstigen Fall der Anwendung der Erfindung auf eine in Multilagertechnik hergestellte Suchspule. Der Einsatz der Erfindung beschränkt sich jedoch keinesfalls auf diesen Anwendungsfall. Vielmehr kann die Erfindung sowohl bei in beliebiger Weise als Leiterplatten hergestellten als auch bei auf herkömmliche Art gewickelten Suchspulen mit Vorteil benutzt werden.

Figur 7 zeigt in Vorderansicht eine Suchspulenanordnung 70 mit einer als Leiterplatte gefertigten Suchspule 72. Dabei kann es sich um eine einfache, eine zweifach beschichtete oder auch um eine mehrlagige Leiterplatte handeln. Suchspulen dieser Art sind in P39 12 840 beschrieben und dargestellt. Oberhalb beziehungsweise unterhalb der Suchspule 72 befinden sich zwei Leiterplatten 74, die den gleichen Zuschnitt aufweisen wie die Suchspule 72. Sie besitzen eine Trägerschicht 76 und einen elektrisch leitenden Belag 78 mit parallelen Leiterbahnen, die durch Verbindungsbahnen untereinander verbunden sind, wie dies in Figur 4 oder 5 dargestellt ist. Durch Verkleben der gegenüberliegenden Flächen der Leiterplatten 72 und der Leiterplatten 74 miteinander ergibt sich eine kompakte Suchspulenanordnung 70 mit einem Schirm, dessen Verbindungsbahnen an das Massepotential des Suchgerätes angeschlossen werden.

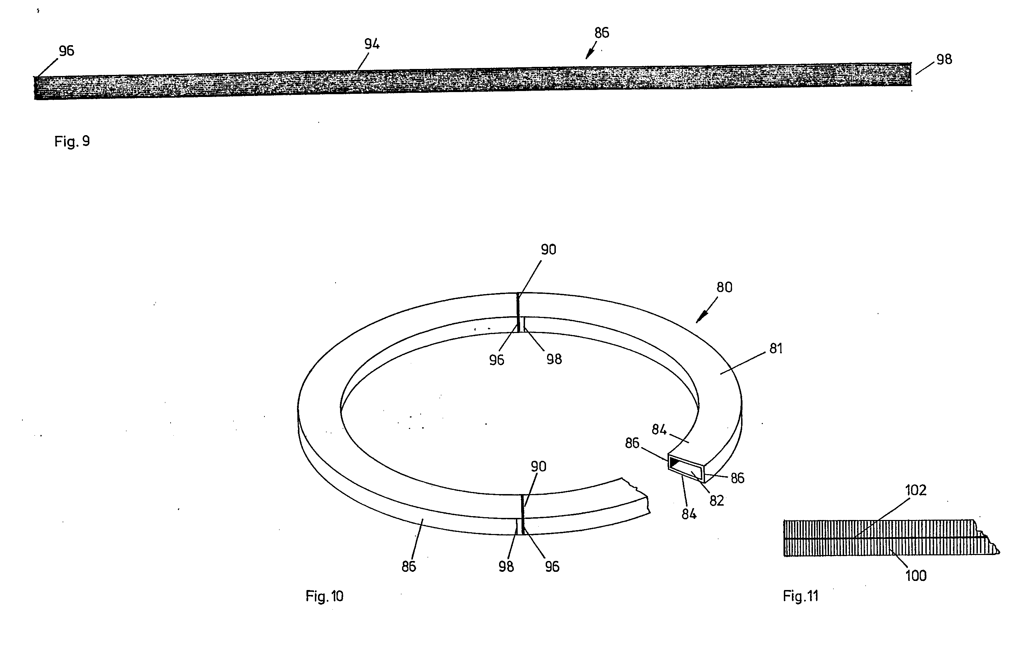

In den Figuren 8, 9 und 10 ist eine Suchspulenanordnung 80 mit einer herkömmlich gewickelten Suchspule 82 dargestellt. Die letztere kann in bekannter Technik als freitragender Wickel hergestellt sein und besitzt einen rechteckigen Querschnitt. Sie ist ganz umschlossen von einem Schirm 81, der aus Leiterplatten 84 und 86 zusammengesetzt ist. Deckel und Boden des Schirmes 81 bestehen aus zwei starren Leiterplatten 84, die Wände sind aus zwei oder vier biegsamen Leiterplatten 86 geformt. Die Leiterplatten 84 besitzen eine Vielzahl von parallelen Leiterbahnen 88, die durch Verbindungsbahnen 90 untereinander verbunden sind. Um das Entstehen von Kurzschlußschleifen zu vermeiden, sind die Leiterbahnen 88 mit Unterbrechungen 92 versehen worden. Die biegsamen Leiterplatten 86 weisen eine Vielzahl paralleler Leiterbahnen 94 auf, die an einer Seite durch eine Verbindungsbahn 96 untereinander verbunden sind, an der anderen Seite jedoch in offene Enden 98 auslaufen. Die Leiterplatten 84 und 86 sind jeweils so montiert, daß die Verbindunsbahnen 90 und 96 zusammenstoßen und elektrisch miteinander kontaktiert werden können. Dabei ist darauf zu achten, daß zwischen den Verbindungsbahnen 96 und den offenen Enden 98 der benachbarten Leiterplatte 86 ein ausreichender Abstand bleibt. Die Verbindungsbahnen 90 und 96 werden an das Massepotential des Suchgerätes angeschlossen. Anstelle der in Umfangs- oder Längsrichtung parallel laufenden Leiterbahnen 88 und 94 der Leiterplatten 84 beziehungsweise 86 können auch in Querrichtung verlaufende Leiterbahnen 100 vorgesehen sein, wie dies in Figur 11 angedeutet ist. In diesem Falle sind die Verbindungsbahnen 102 in Umfangs- beziehungsweise Längsrichtung anzuordnen.

**Ansprüche**

1.) Suchspulenanordnung für ein induktives Suchgerät mit mindestens einer Suchspule (12; 82) zum Herstellen eines veränderlichen Magnetfeldes im Wirkungsbereich der Suchspule (12; 82) und zum Erzeugen elektrischer Signale in der Suchspule (12; 82), wenn ein elektrisch leitender Gegenstand in ihren Wirkungsbereich gelangt und mit einem Schirm (32, 34; 81) aus elektrisch leitendem Material, der mit einem Bezugspotential elektrisch verbunden ist, dadurch gekennzeichnet,
daß der Schirm (32, 34; 81) in der Technik der Leiterplatten aufgebaut ist und eine Trägerschicht (8), sowie einen auf dieser befindlichen dünnen metallischen Belag (6) aufweist, daß der metallische Belag (6) in eine Vielzahl von im wesentlichen parallelen Leiterbahnen (36, 38; 88, 94) aufgelöst ist, die durch Verbindungsbahnen (40, 42, 46, 48; 90, 96) untereinander und mit dem Bezugspotential elektrisch verbunden sind.

2.) Suchspulenzuordnung nach Anspruch 1, dadurch gekennzeichnet,
daß die Leiterbahnen (36, 38; 88, 94) in Form von einfachen geometrischen Bahnen wie Geraden oder Kreisen angeordnet sind.

3.) Spulenanordnung nach Anspruch 1 oder 2, dadurch gekennzeichnet,
daß die Leiterbahnen (36, 38; 88, 94) in im wesentlichen gleichen Abständen angeordnet sind.

4.) Spulenanordnung nach Anspruch 3, dadurch gekennzeichnet,
daß die Abstände (s) zwischen zwei benachbarten Leiterbahnen (38) im wesentlichen gleich breit sind wie die Leiterbahnen (38) selbst.

5.) Spulenanordnung nach einem der vorhergehenden Ansprüche, dadurch gekennzeichnet,
daß die beiden Seiten einer Trägerschicht (60) mit den Leiterbahnen (38) eines Schirmes belegt sind.

6.) Spulenzuordnung nach Anspruch 5, dadurch gekennzeichnet,
daß die Leiterbahnen (38) beider Seiten der Trägerschicht (60) gegeneinander versetzt angeordnet sind, indem jeweils einer Lücke zwischen zwei benachbarten Leiterbahnen (38) einer Seite eine Leiterbahn (38) der anderen Seite gegenüberliegt.

7.) Suchspulenanordnung nach einem der vorhergehenden Ansprüche, dadurch gekennzeichnet,
daß die Suchspule ebenfalls als Leiterplatte (72) aufgebaut ist und daß. der Schirm (74) mit der Ober-und / oder Unterseite der Leiterplatte (10) vorzugsweise durch Aufkleben verbunden ist.

8.) Suchspulenanordnung nach einem der Ansprüche 1 bis 6, dadurch gekennzeichnet,
daß die Suchspule (12) als mehrlagige Leiterplatte (10) aufgebaut ist und daß der Schirm (32, 34) die oberste (a) und/oder unterste (d) Lage der mehrlagigen Leiterplatte (10) einnimmt.

9.) Suchspulenanordnung nach einem der Ansprüche 1 bis 6, dadurch gekennzeichnet,
daß der Schirm (81) aus einer Anzahl von Leiterplatten (84, 86) besteht, die zu einem körperlichen Gebilde zusammengesetzt sind.

10.) Suchspulenanordnung nach Anspruch 9, dadurch gekennzeichnet,
daß das körperliche Gebilde aus starren (84) und biegsamen (86) Leiterplatten zusammengesetzt ist.

Fig. 3

Fig. 2

Fig. 1

32

36

40    46  44

26a    24a

54    48

a    62    56a

30a    50

42

28a    52

38

Fig. 4

38

S    S

60

38'

Fig.6

A 323

34

36

40    46  44

48

26d    24d

d    62

30d

56d

42

28d

Fig. 5

38

A 323

Fig. 7

Fig. 8

EP 0 403 788 A2

96

94

86

98

Fig. 9

90

80

81

96  98

84

86

86

82

84

90

102

86

98  96

100

Fig. 10

Fig. 11